**Europäisches Patentamt**

**European Patent Office**

**Office européen des brevets**

(19)

(11) **EP 1 499 140 A1**

(12) # EUROPEAN PATENT APPLICATION

(43) Date of publication:
**19.01.2005 Bulletin 2005/03**

(51) Int Cl.⁷: **H04Q 7/32**, H04M 1/73

(21) Application number: **03291810.4**

(22) Date of filing: **18.07.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **Freescale Semiconductor, Inc.
Austin, Texas 78735 (US)**

(72) Inventor: **Khlat, Nadim
Cugnaux Midi-Pyrénées 31270 (FR)**

(74) Representative: **Wharmby, Martin Angus
Freescale Semiconductor Inc.
c/o Impetus IP Limited
Grove House
Lutyens Close
Basingstoke, Hampshire RG24 8AG (GB)**

(54) **Battery voltage monitoring and communication mode enabling means for a radiotelephone**

(57) A radiotelephone comprising a battery; a battery monitor for monitoring the battery voltage wherein the radiotelephone is arranged to allow operation within the first frequency band upon determination that the battery voltage is above a first voltage and arranged to allow operation within the second frequency band upon determination that the battery voltage is above a second voltage

FIG. 2

EP 1 499 140 A1

**Description**

The present invention relates to a radiotelephone having a selectable shut down voltage.

A common feature in many radiotelephones is the ability to operate in different frequency bands and with different cellular protocols, thereby allowing a radiotelephone to roam from one cellular network to another. This provides the advantage of allowing a user to continue using their radiotelephone even when travelling and/or working in areas that operate different types of cellular network.

Multiband radiotelephones, in which a radiotelephone is arranged to operate in cellular systems having similar cellular protocols that operate in different frequency bands such as GSM, DCS, PCS, have been available for some time. However, multiband and multimode radiotelephones are now also becoming available in which the radiotelephones are capable of operating in not only cellular networks having similar cellular protocols, such as GSM, DCS and PCS, but are also capable of operating in substantially different types of cellular systems such as GSM and WCDMA.

The design criteria of a multiband and/or multimode radiotelephone will typically require, for cost and aesthetic reasons, that the radiotelephone have a single antenna, even though the radiotelephone's transmitter may have a separate power amplifier for each cellular protocol signal supported by the radiotelephone. To allow the appropriate electromagnetic signals generated by the radiotelephone to be coupled to the antenna from the appropriate radiotelephone power amplifier, where for example one power amplifier will be used for handling WCDMA signals, and another power amplifier will be used for handling GSM signals, a directional coupler or switch will be used between the respective power amplifiers and the antenna.

Further, to avoid noise between the transmitted and received signals of a radiotelephone a filter will typically be placed between the directional coupler and the antenna.

However, insertion losses (i.e. losses that will cause a reduction in power of a signal) can occur to the respective radiotelephone signals as a result of the use of both the directional coupler/switch and the filter, as is well known to a person skilled in the art.

Further, the insertion losses that do occur to signals generated by a radiotelephone will typically be dependent upon the frequency of the signal, and as such will be different for the different cellular bands and/or modes transmitted by the radiotelephone.

For example, typical insertion losses for a GSM signal would be of the order of 2.1dB while a 3.4dB insertion loss may occur for a DCS signal generated by the same radiotelephone and a 3.8dB insertion loss may occur for a PCS signal. However, if worst case insertion losses are considered the worst case insertion loss for DCS could be 3.4db+0.8dB, where 0.8dB represents three times the standard variation giving a total of 4.2dB, while in PCS the worst case insertion losses could be 3.8dB+1.2dB, where 1.2dB represents three times the standard variation giving a total of 5.0dB.

To ensure that a multiband/multimode radiotelephone is compliant with the appropriate cellular transmitter specification requirements account has to be taken of insertion losses when designing the radiotelephone transmitters and its operating characteristics.

For example, the DCS specification requires that the minimum transmitted power output for a DCS radiotelephone should not be lower than 28.5dBm. Therefore, the radiotelephone's DCS power amplifier must be arranged to output at least 28.5dBm to meet the DCS transmitter specification plus 4.2dB to compensate for the worst case insertion loss that may result from the use of directional coupler/switch and filter.

To ensure compliance with the appropriate cellular transmitter specification once a radiotelephone's battery charge has reduced below a certain level such that the radiotelephone can no longer meet the required transmitter output requirement the radiotelephone is arranged to shut down and switched off. As such, by uniformly increasing power to compensate for any possible insertion losses the talk time for all bands and/or modes will be adversely effected.

It is desirable to improve this situation.

In accordance with a first aspect of the present invention there is provided a radiotelephone according to claim 1.

An embodiment of the invention will now be described, by way of example, with reference to the drawings, of which:

Figure 1 shows a radiotelephone according to an embodiment of the present invention;

Figure 2 shows a section of a radiotelephone according to an embodiment of the present invention.

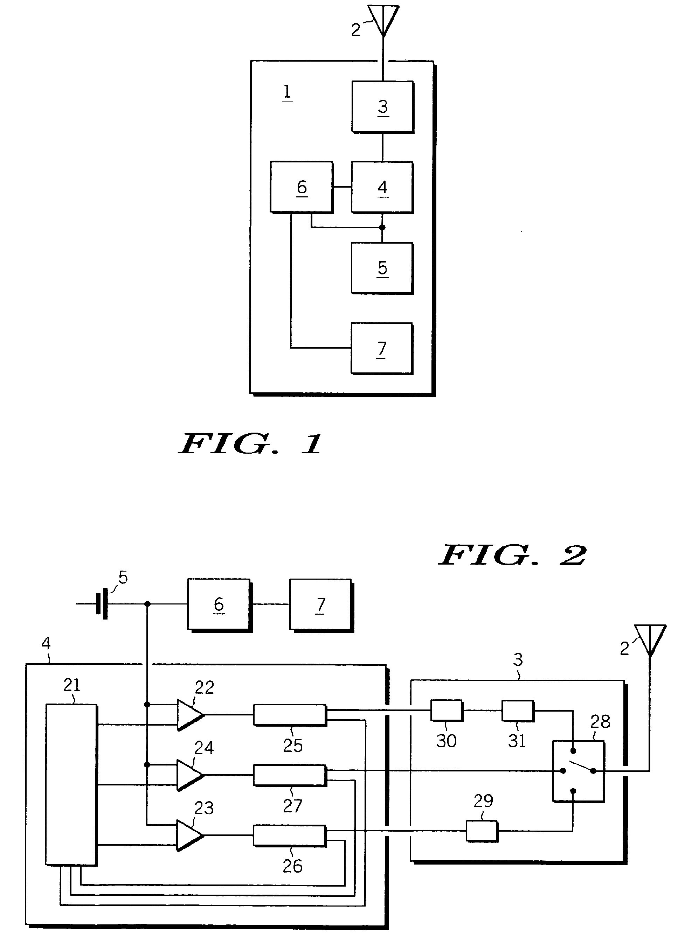

Figure 1 shows a multiband and multimode radiotelephone 1 having an antenna 2, an antenna front end module 3, a transmitter section 4, a battery 5, a battery monitor 6 and a controller 7. In addition to the above features the radiotelephone 1 also includes other conventional features, for example a display, a keypad, a receiver section, that are not necessary for the understanding of the present invention and accordingly are not shown or described in this embodiment.

For the purpose of this embodiment the multiband/multimode radiotelephone 1 is illustrated as being arranged to operate in a WCDMA network, a DCS/PCS network and GSM network. However, this is not restrictive and the radiotelephone 1 could be either a multiband radiotelephone or multimode radiotelephone. Further, the radiotelephone 1 could be designed to operate in other types of networks or combination of networks, as would be appreciated by a person skilled in the art.

As shown in figure 1, the antenna 2 is coupled to the transmitter section 4, via the antenna front end module 3, with the transmitter section 4 being coupled to the battery 5 and battery monitor 6, as described below. Additionally, the battery 5 is coupled to the battery monitor 6 with the battery monitor 6 also being coupled to the controller 7.

As shown in figure 2 the transmitter section 4 includes a first multiband/multimode transmitter module 21 that is arranged to modulate a baseband signal in accordance with the appropriate cellular modulation scheme that applies to the cellular system that the radiotelephone 1 is operating within such that when operating within a GSM network the transmitter module 21 modulates a baseband signal to be within a GSM frequency band, when in a DCS or PCS network the transmitter module 21 modulates a baseband signal to be within a DCS or PCS frequency band and when within a WCDMA network the transmitter module 21 modulates a baseband signal to be within a WCDMA frequency band, as is well known to a person skilled in the art.

The multiband/multimode transmitter module 21 is coupled to a WCDMA power amplifier 22, a DCS/PCS power amplifier 23 and GSM power amplifier 24. Each of the WCDMA power amplifier 22, the DCS/PCS power amplifier 23 and the GSM power amplifier 24 are coupled to a respective power coupler 25, 26, 27 to allow the power amplifier output power for the respective power amplier to be measured for closed loop power control, as is well known to a person skilled in the art. The power couplers 25, 26, 27 introduce insertion losses of the order of 0.2dB.

The outputs from the power couplers 25, 26, 27 are coupled to the antenna front end module, to allow transmission of a signal, in addition to being coupled to the transmitter module, to allow the closed loop power control.

The antenna front end module 3 includes an antenna switch 28 for coupling to the output of the power coupler 25 for the WCDMA path, via a WCDMA transmitter filter 31 and isolator 30; the output of the power coupler 27 for the GSM path; and the output of the power coupler 26 for the DCS/PCS path, via a bandpass filter 29.

The battery 5 is connected to the WCDMA power amplifier 22, the DCS/PCS power amplifier 23, and the GSM power amplifier 24 and is used to drive the WCDMA, DCS/PCS and GSM power amplifiers 22, 23, 24, where the voltage of the battery determines the maximum output power of the respective power amplifiers.

The transmitter section 4 and the front end module 3 operate in a conventional manner with a baseband signal being modulated to a suitable frequency for transmission in an appropriate cellular system, as stated above. The modulated signal is then amplified by an appropriate power amplifier 22, 23, 24 to ensure compliance with the appropriate signal power requirement for the relevant cellular standard, as is well known to a person skilled in the art.

As stated above, the power couplers 25, 26, 27 and front end module, comprising the DCS/PCS filter 29, the transmitter filter 31, isolation 30, and the transmitter switch 28, will cause insertion losses that will need to be compensated for by the appropriate power amplifier.

Due to the different characteristics of the network signals transmitted on the different networks systems (e.g. GSM, DCS, PCS and WCDMA) the insertion losses caused by the front end module 3 on the network signals to be transmitted will be different for the different network types. For example, typical insertion losses for a DCS signal are different to those for a GSM signal due to the extra bandpass filter 29 used in the DCS/PCS signal path. Further, as the PCS frequency band is higher than the DCS frequency band the insertion losses for a PCS signal are higher than those for a DCS signal as the insertion losses associated with the bandpass filter increase with frequency. The insertion losses for a WCDMA signal are different to those for a GSM signal due to the isolator 30 and the WCDMA transmitter filter 31.

Accordingly, the insertion losses caused by the power couplers 25, 26, 27 and the front end module 3 for the different network signals will determine by how much the respective power amplifier 22, 23, 24 will need to compensate the signal power. For example, if a 4.2dB insertion loss occurs for a DCS signal the DCS power amplifier 23 will need to provide a 4.2dB compensation, while if a 5dB insertion loss occurs for a PCS signal the PCS power amplifier 23, which is the same DCS power amplifier 23, will need to provide a 5dB compensation.

The insertion loss power correction required by the respective power amplifiers for the different network type are as follows, where the insertion loss values correspond to a typical insertion loss plus normal distribution standard deviation:

GSM TX Insertion loss = 2.1dB + 0,4 (equivalent to 3*sigma) = 2.5dB

DCS TX Insertion loss = 3.4dB + 0.8dB (equivalent to 3*sigma) = 4.2dB

PCS TX Insertion loss = 3.8dB + 1.2dB (equivalent to 3*sigma) = 5.0dB

WCDMA TX Insertion loss = 5.0dB + 1.3(equivalent to 3*sigma) = 5.3dB

The battery monitor 6 monitors the voltage of the battery and is programmed to provide a shut down signal to the controller 7, for shutting down the radiotelephone 1, if the voltage of the battery 5 goes below a specific value, where the specific value corresponds to a minimum voltage that a power amplifier 22, 23, 24 requires to ensure that the power of a transmitted signal complies with the appropriate network standard.

As the value of the insertion losses, caused by the front end module 3, will be different for the different network signals the battery monitor 6 is configure to provide a shut down signal to the controller 7 at different voltages dependent upon the network type that the radiotelephone 1 is operating within. For example, the shut down voltage for the radiotelephone 1 when operating in a PCS network, which will result in an insertion loss of for example 5 dB's, may be set at 3.3 volts, while the shut down voltage for the radiotelephone 1 when operating in a GSM network, which will result in an insertion loss of for example 2.5 dB's, may be set at 3.0 volts and the shut down voltage when operating in a DCS network, which will result in an insertion loss of 4.2dB will be set to 3.1V.

Further, as the amount of insertion loss caused by the front end module 3 are typically frequency dependent, the shut down voltage may not only be dependent upon which network system a radiotelephone 1 is operating within but may also be dependent upon which frequency band the radiotelephone 1 is operating in where the network system within which the radiotelephone 1 is operating can have more than one frequency band, for example a CDMA network system where the transmit frequency is fixed within a given serving cell (i.e. no frequency hopping is required).

The use of a selectable shut down voltage for different radiotelephone bands or modes has the advantage of increasing radiotelephone talk time when compared with the effect upon radiotelephone talk time for a radiotelephone redesigned to provide greater signal output for a given voltage.

The following provides an illustration of the effect upon talk time for a PCS/DCS radiotelephone that has a selectable shut down voltage compared with a redesigned radiotelephone that provides a higher signal output for a given voltage.

For a typical DCS/PCS power amplifier a supply battery voltage of 3.1V will provide a maximum signal output power of +31.58dbm, a supply battery voltage of 3.2V will provide a maximum signal output power of +31.58dbm+20*log (3.2/3.1)= +31,86dbm, a supply battery voltage of 3.3V will provide a maximum signal output power of +31.58dbm + 20*log(3.3/3.1) = +32,12dbm.

Therefore, when in a PCS mode, to account for insertion losses associated with the PCS path (i.e. 3.8dB), a shut down voltage of 3.3V will be required (i.e. at 3.3V the transmitted signal output power will be +32,12dbm - 3.8dB =+28.32dbm and will be within the PCS specification).

When in a DCS mode, to account for insertion losses associated with the DCS path (i.e. 3.4dB), a shut down voltage of 3.1 V will be required (i.e. at 3.1 V the transmitted signal output power will be +31,58dbm - 3.4dB = +28,18dbm and will be within the DCS specification).

Shutting down the radiotelephone at 3.3V, when in the PCS mode, will result in the effect of not using 5% of available battery capacity, when compared with a shutdown voltage of 3.1.

As the overall current drain for a radiotelephone will typically, when including all radiotelephone modules other than the power amplifiers, be around 220mA this will provide a total talk time of 4.1 hours for a battery useable capacity of 900mAh. Consequently 5% of 4.1 hours corresponds to a talk time reduction of 12 minutes.

The reduction of 12 minutes in talk time when operating in the PCS mode will result in an increase in output power by 0.54dB, to meet 3GPP specs for PCS, and it will not impact the DCS mode (i.e. the most frequently used mode) talk time, which has a shut down voltage of 3.1V.

However, if the DCS/PCS power amplifier is redesigned to provide an output power of +32,12dbm (i.e. to allow compliance with both the PCS and DCS specification requirements) when supplied with a 3.1V it will be necessary to degrade the Power Added Efficiency (PAE) of the power amplifier by 3% from the typical value of 40% (i.e. the power amplifier will need to operate with a PAE of 37%).

This will result in the power amplifier requiring an extra 260mA of current.

That is to say, the total power amplifier peak current drain battery for a battery voltage of 3.1V when providing a signal output of +31.58dbm at 40% PAE is equal to 10^(31.58/10)/0.4/3.1V = 1160mA.

The total power amplifier peak current drain battery for a battery voltage of 3.1V when providing a signal output of +32,12dbm at 37% PAE is equal to 10^(+32,12/10)/0,37/3,1 V = 1420mA.

Consequently the extra Peak current of 1420-1160 = 260mA is required to provide a power amplifier that is capable of complying with the PCS specification when being provided with a battery supply voltage of 3.1V.

However, as DCS/PCS standards only requires a radiotelephone to transmit in 1 out of 8 timeslots the extra average current will be 260mA/8 = 32.5mA, which results in a reduction in talk time by 32 minutes.

Typically the insertion losses between one radiotelephone and another will be different as will the output power, consequently it is possible select the shut down voltage for the different modes/bands for each radiotelephone during factory phasing.

The phasing is done by using the factory phasing measured maximum output power at a given battery voltage and derated by a fixed value to take into account the temperature degradation and the lowest battery voltage to select the appropriate shutdown voltage (i.e. if Max_POWER_Factory is the measured power at a given battery voltage at 3.6V for example and at 25°C ambient temperature, then the expected power under temperature conditions above 60°C and for a battery voltage of 3.1V would be calculated as Max_Power_EXTREME =Max_Power_Factory - Derating_TEMPERATURE - Derating_Voltage and then MAX_POWER_EXTREME is compared to the 3GPP output specifications requirements, if Max_Power_EXTREME > +28dbm , then the shutdown voltage is at 3.1V , if not the shut down voltage is set to a higher value).

**Claims**

1. A radiotelephone comprising a battery; a battery monitor for monitoring the battery voltage wherein the radiotelephone is arranged to allow operation within the first frequency band upon determination that the battery voltage is above a first voltage and arranged to allow operation within the second frequency band upon determination that the battery voltage is above a second voltage.

2. A radiotelephone according to claim 1, wherein the first frequency band corresponds to a first frequency band of a first cellular communication protocol.

3. A radiotelephone according to claim1 or 2, wherein the second frequency band corresponds to a second frequency band of a first cellular communication protocol.

4. A radiotelephone according to claim 1 or 2, wherein the second frequency band corresponds to a second frequency band of a second cellular communication protocol.

5. A radiotelephone according to any of claims 1 to 3, wherein the first cellular communication protocol is GSM.

6. A radiotelephone according to claim 3, wherein the second frequency band of the first cellular communication protocol is PCS or DCS.

7. A radiotelephone according to claim 4, wherein the second cellular communication protocol is WCDMA.

8. A radiotelephone according to any preceding claim, wherein the first voltage and second voltage are selectable.

**FIG. 1**

**FIG. 2**

EP 1 499 140 A1

| | European Patent Office | **EUROPEAN SEARCH REPORT** | Application Number EP 03 29 1810 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 497 507 A (KOMAKI NORIO) 5 March 1996 (1996-03-05) * abstract * * column 2, line 48 - column 4, line 20 * * figures 1,4,5 * | 1-8 | H04Q7/32 H04M1/73 |
| A | EP 1 020 948 A (NOKIA MOBILE PHONES LTD) 19 July 2000 (2000-07-19) * abstract * | 2,3,5,6 | |
| A | DATABASE WPI Section EI, Week 200347 Derwent Publications Ltd., London, GB; Class W01, AN 2003-499985 XP002260204 & JP 2003 168995 A (KENWOOD CORP), 13 June 2003 (2003-06-13) * abstract * | 7 | |
| | | | TECHNICAL FIELDS SEARCHED (Int.Cl.7) H04Q H04M |

The present search report has been drawn up for all claims

| Place of search | Date of completion of the search | Examiner |
|---|---|---|
| MUNICH | 4 November 2003 | Pohl, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

7

**EP 1 499 140 A1**

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2003

| Patent document cited in search report | | Publication date | Patent family member(s) | | Publication date |
|---|---|---|---|---|---|
| US 5497507 | A | 05-03-1996 | JP | 2101062 C | 22-10-1996 |
| | | | JP | 5091017 A | 09-04-1993 |
| | | | JP | 8015267 B | 14-02-1996 |
| | | | US | 5392462 A | 21-02-1995 |
| EP 1020948 | A | 19-07-2000 | GB | 2345194 A | 28-06-2000 |
| | | | CN | 1261211 A | 26-07-2000 |
| | | | EP | 1018777 A2 | 12-07-2000 |
| | | | EP | 1020948 A1 | 19-07-2000 |
| | | | EP | 1020947 A2 | 19-07-2000 |
| | | | GB | 2382723 A ,B | 04-06-2003 |
| | | | JP | 2000196326 A | 14-07-2000 |
| | | | US | 6307512 B1 | 23-10-2001 |
| | | | US | 6271794 B1 | 07-08-2001 |
| | | | US | 6333716 B1 | 25-12-2001 |
| JP 2003168995 | A | 13-06-2003 | NONE | | |

EPO FORM P0459